Europäisches Patentamt

European Patent Office

Office européen des brevets

(19)

(11) **EP 1 598 590 A2**

(12) **EUROPÄISCHE PATENTANMELDUNG**

(43) Veröffentlichungstag:
   **23.11.2005 Patentblatt 2005/47**

(51) Int Cl.[7]: **F21K 7/00**, H01L 33/00

(21) Anmeldenummer: **04030903.1**

(22) Anmeldetag: **28.12.2004**

(84) Benannte Vertragsstaaten:
   **AT BE BG CH CY CZ DE DK EE ES FI FR GB GR
   HU IE IS IT LI LT LU MC NL PL PT RO SE SI SK TR**
   Benannte Erstreckungsstaaten:
   **AL BA HR LV MK YU**

(30) Priorität: **30.12.2003 DE 10361803**

(71) Anmelder: **Osram Opto Semiconductors GmbH
   93049 Regensburg (DE)**

(72) Erfinder: **Blümel, Simon
   84069 Schierling (DE)**

(74) Vertreter: **Epping - Hermann - Fischer
   Ridlerstrasse 55
   80339 München (DE)**

(54) **Beleuchtungsvorrichtung mit optimierter Auskoppelfläche**

(57)   Die Erfindung bezieht sich auf eine Beleuchtungsvorrichtung mit einer Lichtquelle (1), die inkohärentes Licht mit einer Gesamtstrahlungsleistung P emittiert und eine strahlungsemittierende Oberfläche (S) aufweist, die in eine Mehrzahl von Teiloberflächen ($S_i$) unterteilt ist, wobei jeder Teiloberfläche ($S_i$) ein Lichtstrahl (2) mit einer Strahlungsleistung $P_i$ zugeordnet ist und die Summe der Stahlungsleistungen $P_i$ gleich der Gesamtstrahlungsleistung P ist, und einem der Lichtquelle (1) nachgeordneten optischen Element (4) mit einer Auskoppelfläche (5) und einem der Auskoppelfläche (5) zugeordneten Totalreflexionswinkel ($\theta_c$), wobei die Auskoppelfläche (5) so geformt ist, daß zumindest für einen Teil der Lichtstrahlen (2) der Einfallswinkel ($\alpha$) auf die Auskoppelfläche (5) kleiner als der Totalreflexionswinkel ($\theta_c$) ist, und die Strahlungsleistung dieser Lichtstrahlen insgesamt größer als ein vorgegebener Anteil, der mindestens 50% beträgt, der Gesamtstrahlungsleistung P ist.

FIG 1

## Beschreibung

Die vorliegende Erfindung bezieht sich auf eine Beleuchtungsvorrichtung mit einer optimierten Auskoppelfläche.

Derartige Beleuchtungsvorrichtungen umfassen eine Lichtquelle sowie ein der Lichtquelle nachgeordnetes optisches Element mit einer Auskoppelfläche für das von der Lichtquelle emittierte Licht. Dies kann beispielsweise ein Halbleiterchip als Lichtquelle mit einer geeignet geformten Vergussmasse als optischem Element sein.

Für eine möglichst gute Auskopplung des von der Lichtquelle emittierten Lichts ist eine Anpassung des optischen Elements an die Lichtquelle erforderlich.

Bei speziellen Lichtquellen, insbesondere bei kohärenten Lichtquellen wie zum Beispiel Halbleiterlasern, mit einer vergleichsweise wohldefinierten und stark gerichteten Abstrahlcharakteristik können oftmals vorgefertigte und für diese Kategorie von Lichtquellen optimierte optische Elemente bzw. Elementformen, etwa Linsen zur Parallelisierung oder Fokussierung des Lichts, herangezogen werden.

Inkohärente Lichtquellen wie zum Beispiel LED-Chips weisen demgegenüber eine wesentlich kompliziertere Abstrahlungscharakteristik auf, die die Anpassung des optischen Elements wesentlich erschwert.

Bei herkömmlichen Beleuchtungsvorrichtungen wird daher oftmals die Lichtquelle näherungsweise als Punktlichtquelle betrachtet und das optische Element so geformt, dass sich in Verbindung mit einer Punktlichtquelle die gewünschte Abstrahlungscharakteristik ergibt. Insbesondere bei LED-Chips wird diese Näherung aufgrund der vergleichsweise geringen Abmessungen des Chips häufig herangezogen.

Bei derartigen Beleuchtungsvorrichtungen kann es jedoch vorkommen, dass ein erheblicher Teil des erzeugten Lichts nicht an der vorgesehenen Auskoppelfläche austritt, sondern reflektiert und schließlich absorbiert wird.

Oftmals wird zum Ausgleich für diese Reflexionsverluste die Strahlungsleistung der Lichtquelle erhöht. Dies führt aber typischerweise zu einem erhöhten Energieverbrauch und einer höheren thermischen Belastung der Lichtquelle. Falls alternativ bei LED-Chips das Chip-Design zur Erreichung höherer Strahlungsleistungen modifiziert wird, ist hierfür in der Regel ein beträchtlicher Aufwand erforderlich.

Es ist Aufgabe der vorliegenden Erfindung, eine Beleuchtungsvorrichtung der eingangs genannten Art mit verbesserter Effizienz zu schaffen. Insbesondere soll mehr als etwa die Hälfte des von der Lichtquelle erzeugten Lichts direkt ausgekoppelt werden. Bei einer direkten Auskopplung tritt ein von einer Lichtquelle ausgehender Lichtstrahl unmittelbar oder nach Reflexion an einem dafür vorgesehenen Reflektor aus der zugeordneten Auskoppelfläche aus, so dass insbesondere keine Totalreflexion an der Auskoppelfläche erfolgt.

Diese Aufgabe wird durch eine Beleuchtungsvorrichtung gemäß der Ansprüche 1 und 2 gelöst. Vorteilhafte Weiterbildungen der Erfindung sind Gegenstand der abhängigen Ansprüche.

Gemäß einer ersten Ausführungsform der Erfindung ist eine Beleuchtungsvorrichtung mit einer inkohärenten Lichtquelle vorgesehen, die Licht mit einer Gesamtstrahlungsleistung $P$ emittiert und eine lichtemittierende Oberfläche $S$ aufweist, die in eine Mehrzahl von Teiloberflächen $S_i$ unterteilt ist, wobei jeder Teiloberfläche $S_i$ ein Lichtstrahl mit einer Strahlungsleistung $P_i$ zugeordnet ist und die Summe der Strahlungsleistungen $P_i$ gleich der Gesamtstrahlungsleistung $P$ ist. Der Lichtquelle nachgeordnet ist ein optisches Element mit einer Auskoppelfläche, die so geformt ist, dass zumindest für einen Teil der Lichtstrahlen der Einfallswinkel auf die Auskoppelfläche kleiner ist als der der Auskoppelfläche zugeordnete Totalreflexionswinkel, wobei die Strahlungsleistung dieser Lichtstrahlen insgesamt größer ist als ein vorgegebener Anteil $q$ der Gesamtstrahlungsleistung $P$, der bevorzugt mindestens 50% beträgt.

Der Erfindung liegt die Erkenntnis zugrunde, dass die Näherung einer Lichtquelle als Punktlichtquelle oftmals nur bedingt geeignet ist. Bei der Erfindung wird im Gegensatz zu dieser Näherung die Lichtquelle als ausgedehntes Objekt mit einer strahlungsemittierenden Oberfläche $S$ angesehen. Diese Oberfläche ist in eine Mehrzahl von Teiloberflächen $S_i$ unterteilt, wobei jeder Teiloberfläche ein Lichtstrahl mit einer Strahlungsleistung $P_i$ zugeordnet ist. Es sei angemerkt, dass es sich bei dieser Unterteilung um keine Unterteilung im physikalischen Sinn handelt, sondern um eine Zuordnung einer Mehrzahl von Teilflächen $S_i$, die zusammen die Oberfläche $S$ ergeben.

Die den Teiloberflächen zugeordneten Lichtstrahlen besitzen jeweils eine Strahlungsleistung $P_i$ und eine Emissionsrichtung, die beispielsweise anhand experimenteller Untersuchungen der Lichtquelle ermittelt werden kann. Alternativ können diese Parameter auch durch Simulationsrechnungen für die betreffende Lichtquelle gewonnen werden.

Bei einer zweiten Ausführungsform der Erfindung ist eine Beleuchtungsvorrichtung mit einer Lichtquelle vorgesehen, die inkohärentes Licht mit einer Gesamtstrahlungsleistung $P$ emittiert und eine strahlungsemittierende Oberfläche $S$ aufweist, die in eine Mehrzahl von Teiloberflächen $S_i$ unterteilt ist, wobei jeder Teiloberfläche $S_i$ ein Lichtstrahlenbündel mit einer Mehrzahl von Lichtstrahlen der Strahlungsleistung $P_{ij}$ zugeordnet ist, und die Summe der Strahlungsleistungen $P_{ij}$ gleich der Gesamtstrahlungsleistung $P$ ist. Der Lichtquelle nachgeordnet ist ein optisches Element mit einer Auskoppelfläche und einem der Auskoppelfläche zugeordneten Totalreflexionswinkel $\theta_c$, wobei die Auskoppelfläche so geformt ist, dass zumindest für einen Teil der Lichtstrahlen der Einfallswinkel $\alpha$ auf die Auskoppelfläche kleiner als der Totalreflexionswinkel $\theta_c$ ist, und die Strahlungsleistung dieser Lichtstrahlen insgesamt größer ist als ein vorgegebener Anteil q der Gesamtstrahlungsleistung P, der bevorzugt mindestens 50% beträgt.

Bei dieser Variante wird ebenfalls im Gegensatz zu einer Punktlichtquelle die Lichtquelle als ausgedehntes Objekt mit einer strahlungsemittierenden Oberfläche S angesehen und diese Oberfläche in eine Mehrzahl von Teiloberflächen $S_i$ unterteilt, wobei zusätzlich einer Teiloberfläche $S_i$ nicht ein Lichtstrahl, sondern ein Bündel von Lichtstrahlen zugeordnet. Vorteilhafterweise kann so die Abstrahlcharakteristik einer jeden Teiloberfläche berücksichtigt werden, indem die Verteilung der Strahlungsleistungen $P_{ij}$ entsprechend der Abstrahlcharakteristik gewählt wird. Die Abstrahlcharakteristik der einzelnen Teiloberflächen kann beispielsweise durch Simulationsrechnungen, etwa einem Raytracing-Verfahren, ermittelt oder experimentell gemessen werden.

Wiederum sei angemerkt, dass es sich bei Unterteilung in Teiloberflächen nicht um eine Unterteilung im physikalischen Sinn handelt, sondern um eine Zuordnung einer Mehrzahl von Teilflächen $S_i$, die zusammen die Oberfläche S ergeben.

Aus der Ausbreitung der Lichtstrahlen in dem optischen Element ergibt sich für jeden Lichtstrahl, der auf die Auskoppelfläche des optischen Elements trifft, ein Auftreffpunkt. Die Auskoppelfläche ist bei der Erfindung so geformt, dass zumindest für einen Teil der Lichtstrahlen der Einfallswinkel auf die Auskoppelfläche kleiner als der Totalreflexionswinkel ist. Einfallswinkel und Totalreflexionswinkel beziehen sich hier und im Folgenden auf die jeweilige Oberflächennormale der Auskoppelfläche im Auftreffpunkt. Bei einem optischen Element mit einem Brechungsindex $n_1$ und einer angrenzenden Umgebung mit einem kleineren Brechungsindex $n_2$ ist der Totalreflexionswinkel $\theta_c$ gegeben durch

$$\theta_c = \arcsin\frac{n_2}{n_1}$$

Im Fall eines optisch inhomogenen optischen Elements und/oder einer optisch inhomogenen Umgebung sind jeweils die beiden Brechungsindices der an der Auskoppelfläche aneinandergrenzenden Medien im jeweiligen Auftreffpunkt maßgeblich.

Zur Erhöhung der Auskopplung kann als Totalreflexionswinkel auch der Winkel

$$\theta_c = \arcsin\frac{n_2}{n_1} + \varepsilon$$

herangezogen werden, wobei $\varepsilon$ einen Korrekturwinkel zwischen etwa 3° und 5° bezeichnet. Damit wird vermieden, dass die Auskoppelfläche so geformt ist, dass Lichtstrahlen nahezu unter dem Totalreflexionswinkel auf die Auskoppelfläche auftreffen. In diesem Fall würden bereits kleine Fertigungstoleranzen zur Totalreflexion führen.

Lichtstrahlen, die unter einem größeren Winkel als dem Totalreflexionswinkel $\theta_c$ auf die Auskoppelfläche treffen, werden vollständig reflektiert. In der Regel werden diese Strahlen nachfolgend absorbiert oder zumindest in einer nicht beabsichtigten Richtung ausgekoppelt.

Bei der Erfindung trifft somit ein Teil der Lichtstrahlen so auf die Auskoppelfläche, dass keine Totalreflexion auftritt, wobei die Strahlungsleistung dieser Lichtstrahlen insgesamt größer ist als ein vorgegebener, vorzugsweise mindestens 50% betragender Anteil der Gesamtstrahlungsleistung. Damit wird eine vorteilhaft hohe Strahlungsausbeute erzielt.

Das optische Element dient bei der Erfindung zur Führung oder Formung des von der Lichtquelle emittierten Bündels von Lichtstrahlen. Bloße Beschichtungen der Lichtquelle sind in diesem Sinne keine optischen Elemente, da sie von den Lichtstrahlen weitgehend ungehindert durchdrungen werden. Dies trifft insbesondere für dünnwandige Beschichtungen konstanter Schichtdicke zu.

Bei einer bevorzugten Ausführungsform der Erfindung ist die Lichtquelle ein Halbleiterkörper, beispielsweise ein LED-Chip. Aufgrund des typischerweise relativ hohen internen Quantenwirkungsgrads kann mit einem Halbleiterkörper als Lichtquelle eine besonders hohe Effizienz der Beleuchtungsvorrichtung erreicht werden. Zudem kommt der optimalen Anpassung des optischen Elements bei einem Halbleiterkörper als Lichtquelle aufgrund dessen breiter Abstrahlcharakteristik besondere Bedeutung zu.

Im Rahmen der Erfindung ist unter Licht sowohl sichtbares Licht als auch infrarote oder ultraviolette elektromagnetische Strahlung zu verstehen, wobei eine sichtbares Licht emittierende Lichtquelle aufgrund der zahlreichen vorteilhaften Anwendungen bevorzugt ist. So kann die Erfindung beispielsweise in Kraftfahrzeugleuchten oder Signalanlagen wie Ampeln oder Bahnsignalen eingesetzt werden. Derartige Vorrichtungen erfordern eine sehr hohe Lichtleistung, so dass eine erfindungsgemäße Beleuchtungsvorrichtung hoher Effizienz besonders vorteilhaft ist.

Für sichtbares Licht kann im Rahmen der Erfindung die Gesamtstrahlungsleistung bzw. die Strahlungsleistung der Lichtstrahlen durch die entsprechende lichttechnische Größe, den Lichtstrom, ersetzt werden. In diesem Fall ist also der Lichtstrom der Lichtstrahlen, deren Einfallswinkel auf die Auskoppelfläche kleiner als der Totalreflexionswinkel ist, insgesamt größer als ein vorgegebener Anteil des Gesamtlichtstroms der Lichtquelle, der bevorzugt mindestens 50% beträgt.

Bei einer weiteren vorteilhaften Ausgestaltung der Erfindung ist die Lichtquelle zumindest teilweise von dem optischen Element umgeben. Diese Anordnung erleichtert die Formgebung der Auskoppelfläche. Bevorzugt ist dabei das optische Element aus einer Umhüllungsmasse für die Lichtquelle, etwa einer Kunststoffumhüllung geformt. Vorteilhafterweise dient bei dieser Ausgestaltung das optische Element sowohl der optimierten Lichtauskopplung als auch dem Schutz der Lichtquelle gegen schädliche Umwelteinflüsse. Insbesondere bei Halbleiterkörpern ist eine derartige Umhüllung in Form einer den Halbleiterkörper einbettenden Vergussmasse oder Pressmasse zweckmäßig.

Bevorzugt ist bei der Erfindung ein Reflektor für die von der Lichtquelle erzeugte Strahlung vorgesehen. Damit wird der für die Auskoppelfläche relevante Raumwinkel eingeschränkt und in der Folge eine erfindungsgemäße Formgebung der Auskoppelfläche erleichtert. Insbesondere können so Strahlungsanteile, die nicht in Richtung der Auskoppelfläche emittiert werden, in Richtung der Auskoppelfläche reflektiert werden. Damit treffen insgesamt mehr Lichtstrahlen auf die Auskoppelfläche, was einer Erhöhung der Effizienz der Beleuchtungsanordnung entspricht.

Als Material für den Reflektor eignet sich je nach Gestaltung und Einsatzbereich der Beleuchtungsvorrichtung zum Beispiel ein Metall, ein Thermoplast, ein Duroplast oder eine Keramik.

So kann bei einem Halbleiterkörper als Lichtquelle ein Metallreflektor zugleich als Wärmesenke oder als elektrischer Anschluss dienen. Thermoplast- oder Duroplast-Reflektoren sind in Verbindung mit einem Gehäuse für den Halbleiterkörper aus einem entsprechenden Material ohne besonderen Aufwand herstellbar. Ein Keramikreflektor, beispielsweise in Form einer entsprechend geformten Keramikfolie, kann in ein vorgefertigtes Gehäuse eingesetzt werden und zeichnet sich hierbei durch hohe mechanische Festigkeit aus.

Bei dieser Ausgestaltung der Erfindung ist ein Reflektor mit einem hohen Reflexionskoeffizienten für das von der Lichtquelle emittierte Licht vorteilhaft. Hierzu kann der Reflektor mit einer Beschichtung zur Erhöhung des Reflexionskoeffizienten versehen sein. Diese Beschichtung kann beispielsweise als Oberflächenmetallisierung oder eine dielektrische Beschichtung ausgeführt sein. Auch bei einem Metallreflektor, der naturgemäß eine metallisch reflektierende Oberfläche aufweist, kann eine derartige Oberflächenvergütung eine vorteilhafte Verbesserung der Reflexionseigenschaften bewirken.

Weitergehend kann auch ein Gehäuse für die Lichtquelle aus einer Keramik gefertigt sein. Keramikgehäuse zeichnen sich durch eine besonders hohe Strahlungsbeständigkeit im blauen und ultravioletten Spektralbereich aus. Zweckmäßigerweise ist in diesem Fall der Reflektor als Teil des Gehäuses ausgeführt und gegebenenfalls mit einer der oben beschriebenen Beschichtungen versehen.

Bei einer vorteilhaften Weiterbildung dieser Ausgestaltung der Erfindung weist der Reflektor eine CPC-Struktur (Compound Parabolic Concentrator) auf, die zur Abbildung leuchtender Flächen besonders geeignet ist. Derartige CPC-Strukturen sind an sich bekannt und werden daher nicht näher erläutert.

Weitere Merkmale, Vorzüge und Zweckmäßigkeiten der Erfindung ergeben sich aus der nachfolgenden Beschreibung von zwei Ausführungsbeispielen in Verbindung mit den Figuren 1 bis 4.

Es zeigen:

Figur 1 eine schematische Schnittansicht eines ersten Ausführungsbeispiels einer erfindungsgemäßen Beleuchtungsvorrichtung,

Figur 2 eine schematische perspektivische Absicht der Lichtquelle des ersten Ausführungsbeispiels einer erfindungsgemäßen Beleuchtungsvorrichtung,

Figur 3 eine schematische Schnittansicht eines zweiten Ausführungsbeispiels einer erfindungsgemäßen Beleuchtungsvorrichtung,

Figur 4 eine schematische Schnittansicht eines dritten Ausführungsbeispiels einer erfindungsgemäßen Beleuchtungsvorrichtung,

Figur 5 eine schematische Schnittansicht eines vierten Ausführungsbeispiels einer erfindungsgemäßen Beleuchtungsvorrichtung, und

Figur 6 eine schematische Schnittansicht einer Beleuchtungsvorrichtung nach dem Stand der Technik

Gleiche oder gleichwirkende Elemente sind in den Figuren mit denselben Bezugszeichen versehen.

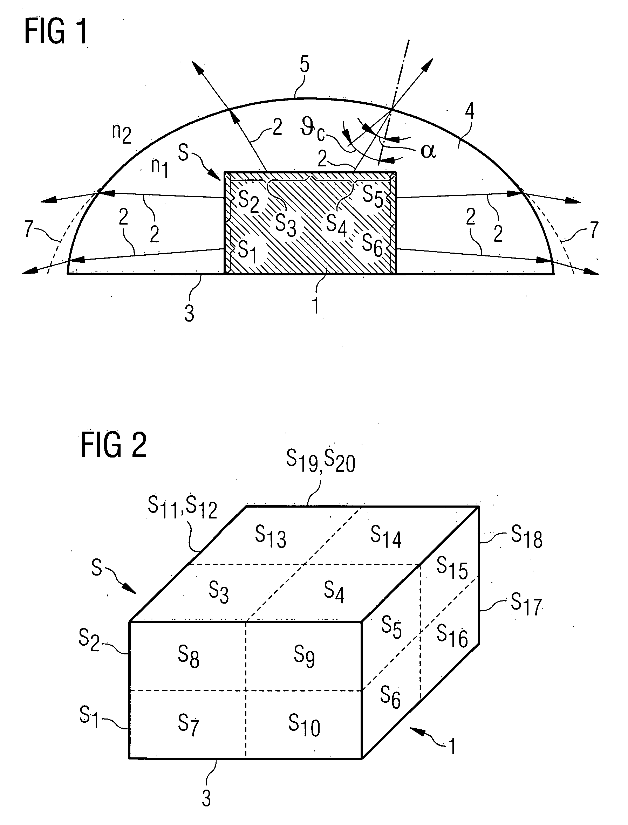

Die in Figur 1 dargestellte Beleuchtungsvorrichtung entsprechend der ersten Ausführungsform der Erfindung weist eine Lichtquelle 1 in Form eines LED-Chips auf, die inkohärentes Licht mit einer Gesamtstrahlleistung P emittiert. Die strahlungsemittierende Oberfläche S der Lichtquelle 1 ist in eine Mehrzahl von Teiloberflächen $S_1$ bis $S_{20}$ unterteilt. Von diesen Teiloberflächen sind aufgrund der Schnittansicht in Figur 1 nur die Teiloberflächen $S_1$ bis $S_6$ dargestellt.

Figur 2 zeigt eine entsprechende Lichtquelle 1 in Form eines LED-Chips in perspektivischer Darstellung. Die Bodenfläche 3 dient als Montagefläche des LED-Chips und stellt daher keine strahlungsemittierende Fläche dar. Die übrigen fünf Seitenflächen der näherungsweise quaderförmigen Lichtquelle 1 bilden die strahlungsemittierende Oberfläche S der Lichtquelle. Diese Seitenflächen sind in jeweils vier Teiloberflächen unterteilt, so dass sich insgesamt eine Unterteilung der strahlungsemittierenden Oberfläche S in 20 Teiloberflächen $S_1$ bis $S_{20}$ ergibt.

Es sei angemerkt, dass im Rahmen der Erfindung auch jede andere Unterteilung vorgenommen werden kann. Diese Unterteilung muss insbesondere weder regelmäßig noch für verschiedene Seitenflächen gleichartig sein. So kann es beispielsweise im Bereich von Kanten und Ecken zweckmäßig sein, eine feinmaschigere Unterteilung vorzunehmen, um die Abstrahlungscharakteristik in diesen Bereichen genauer wiederzugeben.

Bei dem in Figur 1 dargestellten Ausführungsbeispiel ist jeder Teiloberfläche $S_i$ ein Lichtstrahl 2 mit einer Strahlungsleistung $P_i$ zugeordnet. Die Summe der Strahlungsleistungen aller Lichtstrahlen ist dabei gleich der Gesamtstrahlungsleistung:

$$\sum_i P_i = P$$

Die Strahlungsleistung $P_i$ und die Richtung der einzelnen Lichtstrahlen hängt von den konkreten Eigenschaften der Lichtquelle ab. Diese können beispielsweise experimentell ermittelt werden, indem die räumliche Abstrahlungscharakteristik der Lichtquelle gemessen wird. Alternativ kann auch die Abstrahlungscharakteristik aus Simulationsrechnungen für die Lichtquelle bestimmt werden. Insbesondere für LED-Chips können derartige Simulationen mit Raytracing-Verfahren durchgeführt werden, wobei die geometrische Struktur des LED-Chips zugrundegelegt wird.

Weiterhin weist das in Figur 1 dargestellte Ausführungsbeispiel ein optisches Element 4 mit einer Auskoppelfläche 5 auf. Das optische Element ist aus einer Vergussmasse geformt, in die die Lichtquelle 6 eingebettet ist. Als Vergussmasse kann beispielsweise ein Kunststoff, bevorzugt ein Reaktionsharz dienen. Hierfür eignen sich zum Beispiel Epoxydharze, Acrylharze, Silikonharze oder Mischungen dieser Harze.

Die Auskoppelfläche 5 des optischen Elements ist so geformt, dass alle Lichtstrahlen unter einem Einfallswinkel $\alpha$ auf die Auskoppelfläche treffen, der kleiner als der Totalreflexionswinkel $\theta_c$ ist. Für ein optisches Element 4 mit einem Brechungsindex $n_1$ und einer angrenzenden Umgebung mit einem kleineren Brechungsindex $n_2$ ist der Totalreflexionswinkel gegeben durch

$$\theta_c = \arcsin\frac{n_2}{n_1}$$

bzw.

$$\theta_c = \arcsin\frac{n_2}{n_1} + \varepsilon,$$

wobei $\varepsilon$ wiederum den oben angegebenen Korrekturwinkel bezeichnet. Einfallswinkel und Totalreflexionswinkel sind dabei jeweils auf die Oberflächennormale der Auskoppelfläche 5 im Auftreffpunkt des entsprechenden Lichtstrahls 2 bezogen.

Das in Figur 1 dargestellte Ausführungsbeispiel stellt eine bevorzugte Ausgestaltung der Erfindung dar, bei der für keinen der betrachteten Lichtstrahlen Totalreflexion auftritt. Im Rahmen der Erfindung ist es jedoch ausreichend, dass für einen Teil der Lichtstrahlen keine Totalreflexion auftritt, wobei die Strahlungsleistung dieser Lichtstrahlen insgesamt größer ist als ein vorgegebener Anteil der Gesamtstrahlungsleistung P, der vorzugsweise mindestens 50% beträgt.

Eine erfindungsgemäße Auskoppelfläche kann beispielsweise gefunden werden, indem von einer bekannten, etwa kugelförmigen Auskoppelfläche ausgegangen wird, und nachfolgend die Krümmung dieser Fläche in Teilbereichen so lange variiert wird, bis für einen Teil der Lichtstrahlen keine Totalreflexion mehr auftritt, wobei die Strahlungsleistung dieser Lichtstrahlen insgesamt größer ist als der vorgegebene Anteil Gesamtstrahlungsleistung P. Hierfür eignen sich bekannte computergestützte Variationsund Optimierungsverfahren. Vorzugsweise wird die als Ausgangspunkt verwendete Auskoppelfläche zunächst daraufhin analysiert, in welchen Bereichen vermehrt Totalreflexion auftritt, und danach die Krümmung in diesen Bereichen variiert.

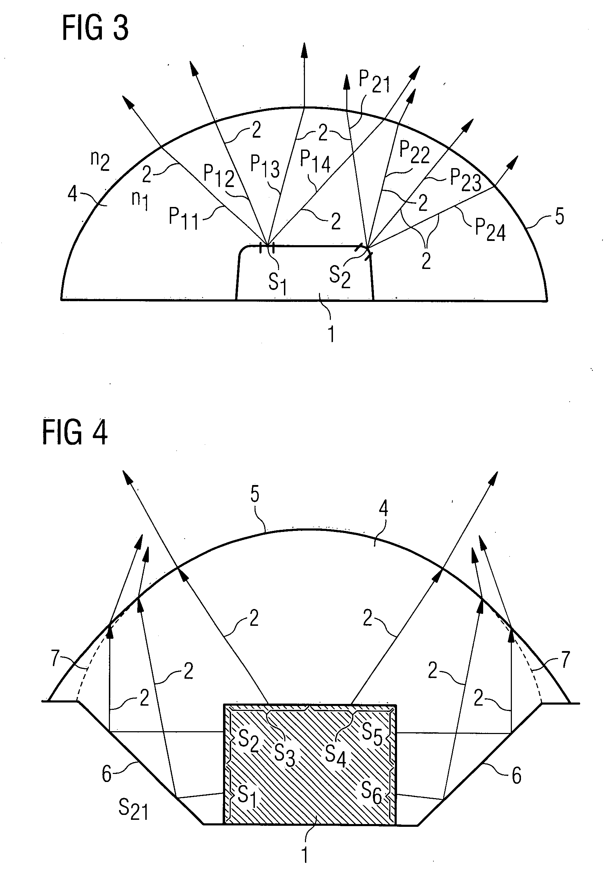

Figur 3 zeigt eine schematische Schnittansicht eines zweiten Ausführungsbeispiels der Erfindung gemäß der zweiten Ausführungsform. Die dargestelle Beleuchtungsvorrichtung umfasst wie das zuvor beschriebene erste Ausführungsbeispiel eine Lichtquelle 1 sowie ein optisches Element 4 mit einer Auskoppelfläche 5, wobei die strahlungsemittierende Oberfläche der Lichtquelle 1 in eine Mehrzahl von Teiloberflächen $S_i$ (beispielhaft dargestellt anhand der beiden Teiloberflächen $S_1$ und $S_2$) unterteilt ist. Im Unterschied zum ersten Ausführungsbeispiel ist jeder Teiloberfläche nicht ein Lichtstrahl, sondern ein Lictstrahlenbündel mit jeweils einer Mehrzahl von Lichtstrahlen 2 zugeordnet. Die Gesamtstrahlungsleistung P der Lichtquelle ist gleich der Doppelsumme aller Strahlungsleistungen $P_{ij}$ der Lichtstrahlen, wobei jeweils über alle Lichtstrahlen einer jeden Teiloberfläche $S_i$ und über alle Teiloberflächen $S_i$ zu summieren ist:

$$\sum_j \sum_i P_{ij} = P$$

Durch diese weitere Zuordnung einer Mehrzahl von Lichtstrahlung zu jeder Teiloberfläche $S_i$ kann die Abstrahlungscharakteristik der Teiloberflächen berücksichtigt werden, indem die Verteilung der Strahlungsleistungen $P_{ij}$ entsprechend der jeweiligen Abstrahlungscharakteristik gewählt wird.

Dies bedeutet beispielsweise, dass einer Teiloberfläche $S_i$, von der aus Strahlung in verschiedene Richtungen ê mit verschiedener Intensität $I_i(ê)$ emittiert

wird, ein Bündel von Lichtstrahlen zugeordnet wird, wobei für die Strahlungsleistung $P_{ij}$ eines Lichtstrahls mit einer Richtung ê gilt:

$$P_{ij} = k \, I_i(\hat{e}),$$

wobei k einen Proportionalitätsfaktor darstellt. Dieser Proportionalitätsfaktor k kann zum Beispiel so gewählt werden, dass die Summe aller Strahlungsleistungen $P_{ij}$ einer Teiloberfläche $S_i$ gleich der über alle Raumrichtungen integrierten Intensität ist:

$$\sum_j P_{ij} = \int I_i(\hat{e}) \, d\Omega \; .$$

Die Auskoppelfläche 5 des optischen Elements ist hierbei derart geformt, dass zumindest für einen Teil der Lichtstrahlen 2 der Einfallswinkel α auf die Auskoppelfläche 5 kleiner als der Totalreflexionswinkel $\theta_c$ ist, wobei und die Strahlungsleistung dieser Lichtstrahlen insgesamt größer ist als ein vorgegebener Anteil q der Gesamtstrahlungsleistung P, der vorzugsweise mindestens 50% beträgt.

Für ein optisches Element 4 mit einem Brechungsindex $n_1$ und einer angrenzenden Umgebung mit einem kleineren Brechungsindex $n_2$ ist der Totalreflexionswinkel gegeben durch

$$\theta_c = \arcsin \frac{n_2}{n_1}$$

bzw.

$$\theta_c = \arcsin \frac{n_2}{n_1} + \varepsilon,$$

wobei ε wiederum den oben angegebenen Korrekturwinkel bezeichnet. Einfallswinkel und Totalreflexionswinkel sind wiederum jeweils auf die Oberflächennormale der Auskoppelfläche 5 im Auftreffpunkt des entsprechenden Lichtstrahls 2 bezogen.

In Figur 4 ist ein drittes Ausführungsbeispiel einer erfindungsgemäßen Beleuchtungsvorrichtung gemäß der ersten Ausführungsform dargestellt. Die Lichtquelle 1, die Unterteilung der strahlungsemittierenden Oberfläche S in Teilflächen $S_i$ und die Zuordnung der Lichtstrahlen 3 entsprechen im wesentlichen dem in Figur 1 und 2 dargestellten ersten Ausführungsbeispiel.

Weiterhin ist bei dem zweiten Ausführungsbeispiel ein Reflektor 6 vorgesehen. Dieser Reflektor 6 lenkt die seitlich abgestrahlten Strahlungsanteile um, so dass der für die Auskoppelfläche relevante Raumwinkel eingeschränkt ist. Damit kann die Größe der Auskoppelfläche bzw. deren Platzbedarf vorteilhaft reduziert werden. Weiterhin wird die Formgebung der Austrittsfläche aufgrund der stärker gerichteten Emission erleichtert.

Die Auskoppelfläche ist wie bei dem ersten Ausführungsbeispiel so geformt, dass keine Totalreflexion der betrachteten Lichtstrahlen auftritt, wobei es im Rahmen der Erfindung ausreicht, dass für einen Teil der Lichtstrahlen keine Totalreflexion auftritt, und die Strahlungsleistung dieser Lichtstrahlen insgesamt mindestens 50% der Gesamtstrahlungsleistung P beträgt.

Der Reflektor 6 kann als Teil eines Duroplast- oder Thermoplastgehäuses gefertigt sein. Alternativ kann der Reflektor als Metall- oder Keramikeinsatz für ein vorgefertigtes Gehäuse ausgeführt sein. Bevorzugt ist auf dem Reflektor 6 eine Beschichtung aufgebracht, die den Reflexionskoeffizienten für die von der Lichtquelle 1 emittierte Strahlung erhöht. Dies kann beispielsweise eine Oberflächenmetallisierung oder eine dielektrische Beschichtung sein.

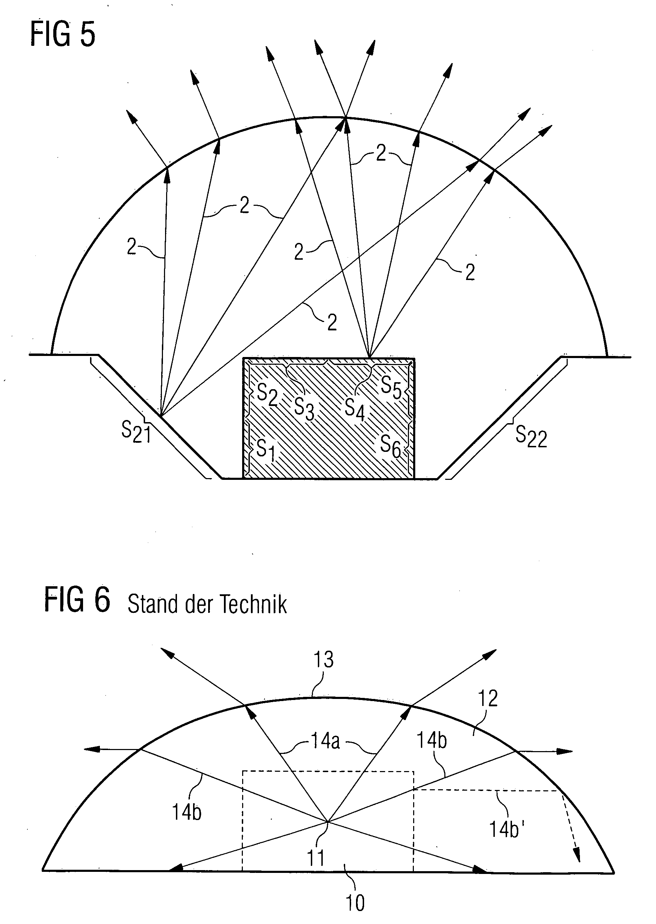

Figur 5 zeigt ein viertes Ausführungsbeispiel einer erfindungsgemäßen Beleuchtungsvorrichtung gemäß der zweiten Ausführungsform. Die Lichtquelle 1, die Unterteilung der strahlungsemittierenden Oberfläche-S in Teilflächen $S_i$, die Zuordnung der Lichtstrahlen 3 und der Reflektor 6 selbst entsprechen im wesentlichen dem in Figur 4 dargestellten dritten Ausführungsbeispiel.

Allerdings ist wie bei dem in Figur 3 gezeigten zweiten Ausführungsbeispiel jeder Teiloberfläche $S_i$ ein Bündel von mehreren Lichtstrahlen zugeordnet. Weiterhin wird auch der Reflektor 6, der zumindest teilweise diffus reflektieren kann, in diese Betrachtung miteinbezogen und dessen Oberfläche ebenfalls in Teiloberflächen $S_i$ unterteilt. Es kann somit bei der Erfindung auch ein Reflektor als Teil der Lichtquelle angesehen werden.

Die Auskoppelfläche 5 ist so geformt, dass für einen Teil der Lichtstrahlen keine Totalreflexion auftritt, und die Strahlungsleistung dieser Lichtstrahlen insgesamt größer ist als ein vorgegebener Anteil der Gesamtstrahlungsleistung, wobei dieser Anteil bevorzugt 50% beträgt.

In Figur 6 ist zum Vergleich eine Beleuchtungsvorrichtung nach dem Stand der Technik dargestellt. Diese Beleuchtungsvorrichtung umfasst eine Lichtquelle 10, die näherungsweise als Punktlichtquelle mit einem Zentrum 11 in der Mitte der Lichtquelle betrachtet wird. Die Lichtquelle ist in ein optisches Element 12 mit einer sphärischen Auskoppelfläche 13 eingebettet.

In der Näherung der Punktlichtquelle treffen die Lichtstrahlen 14a und 14b unter einem Winkel auf die Auskoppelfläche, der kleiner als der Totalreflexionswinkel ist. Diese Näherung ist jedoch, wie ein Vergleich mit Figur 1 zeigt, für die seitlich emittierten Lichtstrahlen 14b schlecht erfüllt. Insbesondere treffen diese Lichtstrahlen, wie der vergleichsweise eingezeichnete Lichtstrahl 14b' zeigt, in der Realität deutlich flacher auf die Auskoppelfläche 13 und werden dort totalreflektiert. Insgesamt können daher bei einer Auskoppelfläche, die anhand herkömmlicher Näherungen geformt ist und hiernach einen hohen Auskopplungsgrad aufweist, erhebliche Reflexionsverluste auftreten.

Bei der Erfindung hingegen ist, wie Figur 1 zeigt, die Auskoppelfläche dahingehend optimiert, dass auch die seitlich emittierten Lichtstrahlen ausgekoppelt werden. Hierzu ist bei dem in Figur 1 dargestellten Ausführungsbeispiel in Abweichung von der Kugelform die Krümmung der Auskoppelfläche 5 in den Randbereichen so modifiziert, so dass der Einfallswinkel der seitlich emittierten Lichtstrahlen kleiner als der Totalreflexionswinkel ist. Für die (zum Vergleich gestrichelt eingezeichnete) Kugelform 7 nach dem Stand der Technik ist der Einfallswinkel für die seitlich emittierten Lichtstrahlen deutlich größer, so dass Totalreflexionsverluste auftreten können.

Bei dem in den Figur 2 und 3 dargestellten Ausführungsbeispiel hingegen ist die Krümmung der Auskoppelfläche 5 in den Randbereichen so modifiziert, so dass für die durch den Reflektor 6 umgelenkten bzw. vom Reflektor 6 ausgehenden Lichtstrahlen der Verlust durch Totalreflexion vermindert ist. Auch hier würde die (zum Vergleich gestrichelt eingezeichnete) Kugelform 7 nach dem Stand der Technik zu Totalreflexionsverlusten führen.

Die Erfindung ist nicht durch die Beschreibung anhand der Ausführungsbeispiele beschränkt. Insbesondere bezieht sich die Erfindung auf beliebige Lichtquellen, die nicht notwendigerweise einen Halbleiterchip enthalten müssen. Auch kann die Lichtquelle mehrere Komponenten wie beispielsweise einen LED-Chip und eine Umhüllung zur Wellenlängenkonversion, wie sie zur Erzeugung von mischfarbigen und insbesondere weißem Licht verwendet wird, aufweisen. Weitergehend kann die Lichtquelle ihrerseits eine Beleuchtungsvorrichtung gemäß der vorliegenden Erfindung sein.

Die Erfindung umfasst jedes neue Merkmal sowie jede Kombination von Merkmalen, was insbesondere jede Kombination von Merkmalen in den Patentansprüchen beinhaltet, auch wenn diese Kombination nicht explizit in den Patentansprüchen angegeben ist.

**Patentansprüche**

1. Beleuchtungsvorrichtung mit einer Lichtquelle (1), die inkohärentes Licht mit einer Gesamtstrahlungsleistung P emittiert und eine strahlungsemittierende Oberfläche (S) aufweist, die in eine Mehrzahl von Teiloberflächen ($S_i$) unterteilt ist, wobei jeder Teiloberfläche ($S_i$) ein Lichtstrahl (2) mit einer Strahlungsleistung $P_i$ zugeordnet ist, und die Summe der Strahlungsleistungen $P_i$ gleich der Gesamtstrahlungsleistung P ist, und einem der Lichtquelle (1) nachgeordneten optischen Element (4) mit einer Auskoppelfläche (5) und einem der Auskoppelfläche (5) zugeordneten Totalreflexionswinkel ($\theta_c$), wobei die Auskoppelfläche (5) so geformt ist, dass zumindest für einen Teil der Lichtstrahlen (2) der Einfallswinkel ($\alpha$) auf die Auskoppelfläche (5) kleiner als der Totalreflexionswinkel ($\theta_c$) ist, und die Strahlungsleistung dieser Lichtstrahlen insgesamt größer ist als ein vorgegebener Anteil q der Gesamtstrahlungsleistung P.

2. Beleuchtungsvorrichtung mit einer Lichtquelle (1), die inkohärentes Licht mit einer Gesamtstrahlungsleistung P emittiert und eine strahlungsemittierende Oberfläche (S) aufweist, die in eine Mehrzahl von Teiloberflächen ($S_i$) unterteilt ist, wobei jeder Teiloberfläche ($S_i$) ein Lichtstrahlenbündel mit einer Mehrzahl von Lichtstrahlen (2) der Strahlungsleistung $P_{ij}$ zugeordnet ist, und die Summe der Strahlungsleistungen $P_{ij}$ gleich der Gesamtstrahlungsleistung P ist, und einem der Lichtquelle (1) nachgeordneten optischen Element (4) mit einer Auskoppelfläche (5) und einem der Auskoppelfläche (5) zugeordneten Totalreflexionswinkel ($\theta_c$), wobei die Auskoppelfläche (5) so geformt ist, dass zumindest für einen Teil der Lichtstrahlen (2) der Einfallswinkel ($\alpha$) auf die Auskoppelfläche (5) kleiner als der Totalreflexionswinkel ($\theta_c$) ist, und die Strahlungsleistung dieser Lichtstrahlen insgesamt größer ist als ein vorgegebener Anteil q der Gesamtstrahlungsleistung P.

3. Beleuchtungsvorrichtung nach Anspruch 2, bei der den Teiloberflächen ($S_i$) jeweils eine Abstrahlcharakteristik zugeordnet ist, und die Verteilung der Strahlungleistungen $P_{ij}$ einer Teiloberfläche ($S_i$) jeweils der zugehörigen Abstrahlcharakteristik entspricht.

4. Beleuchtungsvorrichtung nach Anspruch 1 oder 2, bei der der vorgegebene Anteil q mindestens 50% beträgt.

5. Beleuchtungsvorrichtung nach einem der Ansprüche 1 bis 4, bei der die Lichtquelle (1) ein Halbleiterkörper ist.

6. Beleuchtungsvorrichtung nach einem der Ansprüche 1 bis 5, bei der die Lichtquelle (1) sichtbares Licht emittiert.

7. Beleuchtungsvorrichtung nach einem der Ansprüche 1 bis 6, bei der die Lichtquelle (1) von dem optischen Element (4) zumindest teilweise umgeben ist.

8. Beleuchtungsvorrichtung nach Anspruch 7, bei der das optische Element (4) aus einer Umhüllungsmasse für die Lichtquelle (1) geformt ist.

9. Beleuchtungsvorrichtung nach Anspruch 8,
   bei der die Umhüllungsmasse ein Kunststoff ist.

10. Beleuchtungsvorrichtung nach Anspruch 9,
    bei der die Umhüllungsmasse ein Reaktionsharz ist.

11. Beleuchtungsvorrichtung nach einem der Ansprüche 1 bis 7,
    bei der ein Reflektor (6) für das von der Lichtquelle (1) emittierte Licht vorgesehen ist.

12. Beleuchtungsvorrichtung nach Anspruch 11,
    bei der der Reflektor (6) ein Metall enthält oder mit einer metallisierten Oberfläche versehen ist.

13. Beleuchtungsvorrichtung nach Anspruch 12,
    bei der-der Reflektor (6) einen Duroplast enthält.

14. Beleuchtungsvorrichtung nach Anspruch 12,
    bei der der Reflektor (6) einen Thermoplast enthält.

15. Beleuchtungsvorrichtung nach Anspruch 12,
    bei der der Reflektor (6) eine Keramik enthält.

16. Beleuchtungsvorrichtung nach einem der Ansprüche 11 bis 15,
    bei der der Reflektor (6) eine Beschichtung zur Erhöhung der Reflexion des von der Lichtquelle (1) emittierten Lichts aufweist.

17. Beleuchtungsvorrichtung nach einem der Ansprüche 11 bis 16,
    bei der der Reflektor eine CPC-Struktur aufweist.

## FIG 1

## FIG 2

EP 1 598 590 A2

FIG 3

$P_{21}$
$n_2$
$n_1$
$P_{12}$ $P_{13}$ $P_{14}$
$P_{11}$
$P_{22}$
$P_{23}$
$P_{24}$
4
2 2 2 2 2 2
5
$S_1$ $S_2$
1

FIG 4

5
4
2 2
7 7
2 2 2 2
2 2
6 6
$S_2$ $S_3$ $S_4$ $S_5$
$S_1$ $S_6$
$S_{21}$
1

## FIG 5

S21   S2   S3   S4   S5   S1   S6   S22

## FIG 6   Stand der Technik

13   12   14a   14b   14b   11   14b'   10